# EUROPEAN PATENT SPECIFICATION

(11) **EP 3 879 281 B1**
(45) Date of publication and mention of the grant of the patent: **20.12.2023**
(21) Application number: 20162739.5
(22) Date of filing: 12.03.2020
(51) Int. Cl.: G01R 27/18

(54) **METHOD FOR MONITORING ISOLATION OF AN UNGROUNDED DC BUS**
VERFAHREN ZUR ÜBERWACHUNG DER ISOLATION EINES UNGEERDETEN GLEICHSPANNUNGSBUSSES
PROCÉDÉ DE SURVEILLANCE D'ISOLATION D'UN BUS CC NON MIS À LA TERRE

(43) Date of publication of application: 15.09.2021
(73) Proprietor: ABB E-mobility B.V., 2629 JG Delft (NL)
(72) Inventor: Koolen, Gertjan, 5622 Eindhoven (NL); Bech, Lars Peter, 3119 Schiedam (NL); Raaijmakers, Stefan, 2613 Delft (NL)
(74) Representative: Maiwald GmbH

(56) References cited:
- EP-A1- 2 869 075
- WO-A1-2010/069739
- US-A- 4 528 497

## Description

### Technical Field

The invention relates to a method for monitoring isolation of an ungrounded DC, direct current, bus of an electric vehicle supply equipment, EVSE, comprising the steps of applying a periodical test signal having a frequency on the DC bus, measuring a voltage and/or current fluctuation on the DC bus resulting from the test signal, correlating the test signal with the fluctuation resulting in a vector and determining the isolation of the DC bus by using the vector. The invention further relates to an electric vehicle supply equipment, EVSE, comprising an ungrounded DC, direct current, bus for connecting an electric vehicle, EV, to the EVSE, a test signal source configured for applying a periodical test signal having a frequency on the DC bus, a measurement device configured for measuring a voltage and/or current fluctuation on the DC bus resulting from the test signal and an evaluation device configured for correlating the test signal with the fluctuation resulting in a vector, and wherein the evaluation device is further configured for determining an isolation of the DC bus by using the vector.

### Background Art

Electrical distribution of AC, alternating current, or DC, direct current, power can be isolated or non-isolated, for example in AC IT, isol6e terre, power grids or DC solar panels. In an isolated topology it is common practise to have an isolation monitor to guard the isolation resistance to ground. The resistance to ground is a complex value which is composed of an ohmic isolation resistance of interest as its real part and of a capacitive reactance to ground as its imaginary part. The capacitive reactance to ground is a result of leakage capacitances of the power grid which are effective with respect to ground.

When steps or transients on the electrical voltage or current happen, monitoring of the isolation becomes problematic since the isolation measurements are usually based on common-mode voltage and currents. Especially in case of EV, electric vehicle, chargers respectively charging systems several steps and transients are usually expected during a charging session. EV charging standards UL and SAE J1772 require a short detection time of 10 s, which is challenging for higher capacitances and resistances that are defined in said standards. Future versions of standard IEC61851-23 are also expected to require such 10 s detection time. Besides heavy EVs usually exceed said limit as set by the EV standards, as said heavy EVs do not yet need to comply to these standards. Such wise detection of the isolation resistance to ground becomes slower and more challenging.

It is known from prior art to inject a small periodical voltage onto a DC bus of the EV charger providing electrical power for charging the EV, to measure a therefrom resulting current fluctuation and to correlate the voltage and the measured current with each other in order to get rid of non-relevant voltages on the DC bus. However, isolation monitoring in EV charging needs to be fast when there is low capacitance on the DC bus and slow when there is a high capacitance on the DC bus. At a beginning of a charging session, in particular during a so-called cable-check phase, when the EV has not yet connected its batteries to the DC bus, capacitance on the DC bus is usually low. During said phase a quick detection within few seconds is required, since the detection adds up to a total charging session time. High capacitance is usually present during power delivery as main phase of the charging session. In order to waste no time in switching or settling of internal detection signals, it needs to be switched quickly between said two modes, which actually contradict each other. Prior art, in particular as mentioned before, is however mute of an appropriate solution for said problem.

Document EP 2 869 075 A1 relates to a system and method for detecting a leakage from power cables of a DC bus to ground.

Document US 4,528,497 A relates to a method and apparatus for monitoring ground faults in an ungrounded power distribution system.

Document WO 2010 069 739 A1 relates to a ground fault detection system for a generator of a power system.

### Summary of invention

It is therefore an object of the invention to provide an advantageous solution for monitoring isolation of an ungrounded DC, direct current, bus, in particular for an electric vehicle supply equipment, EVSE.

The object of the invention is solved by the features of the independent claims. Preferred embodiments are detailed in the dependent claims.

Thus, the object is solved by a method for monitoring isolation of an ungrounded DC, direct current, bus of an electric vehicle supply equipment, EVSE, comprising the steps of:
Applying a first periodical test signal having a first frequency and applying a second periodical test signal having a second frequency on the DC bus, whereby the second frequency is greater than the first frequency,
Measuring a first voltage and/or current fluctuation on the DC bus resulting from the first test signal and measuring a second voltage and/or current fluctuation on the DC bus resulting from the second test signal, and
Correlating the first test signal with the first fluctuation resulting in a first vector and correlating the second test signal with the second measured fluctuation resulting in a second vector.
Band pass-filtering the second fluctuation and subtracting the band pass-filtered second fluctuation from the first fluctuation and band pass-filtering the first fluctuation and subtracting the band pass-filtered first fluctuation from the second fluctuation, whereby the step of correlating comprises
Correlating the first test signal with the band pass-filtered first fluctuation resulting in the first vector and correlating the second test signal with the band pass-filtered second fluctuation resulting in the second vector.

In a preferred implementation the method comprises the step of:
Determining the isolation of the DC bus by using the second vector for, and if the second vector falls below a threshold, determining the isolation of the DC bus by using the first vector.

It is therefore a key aspect of the invention that, opposite to prior art, where the frequency is varied in such a way that ohmic detection is possible, constant frequencies i.e. at least two different frequencies are applied and that in particular real and imaginary parts of a response thereto as fluctuation are measured, and based thereon that the isolation of the DC bus is calculated, in particular as ohmic resistance and capacitance reactance. Each injected frequency results in a vector after correlation with its original source i.e. with the test signal. The proposed solution allows detection of isolation faults for standards such as UL and SAE J1772 or even upcoming versions IEC61851-23 requiring a short detection time of maximum 10 s, even when using higher capacitances and resistances as defined in the respective standard. Generally, two frequencies affect each other since band pass filters and correlators cannot filter them out completely, as sufficient fast response times are required for fulfilling said standards. For solving such potential problem, the method determines the isolation of the DC bus preferably first by using the second vector, and if the second vector falls below a threshold, by using the first vector, thereby making use of both frequencies depending if low of high capacitance is on the DC bus. Determining the isolation means in particular determining if an isolation fault happened.

The electric vehicle supply equipment, EVSE, also referred to as electric vehicle, EV, charging station, electric recharging point, charging point, charge point, charge post or electronic charging station, ECS. The EVSE is an element in an infrastructure that supplies electric energy for recharging of electric vehicles, including electric cars, neighbourhood electric vehicles and plug-in hybrids, via a charging cable and a charging connector to the EV. EVSEs usually comply with standards for electric vehicle fast charging, such as the so-called Combined Charging System, CCS, protocol according to IEC 61851-23 and SAE J1772 standard for charging electric vehicles both in the US and in the European Union, EU. The Combined Charging System, CCS, protocol is a fast charging method for charging electric vehicles delivering high-voltage direct current via a charging connector derived from SAE J1772 standard (IEC Type 1) or IEC Type 2 connector. Automobile manufactures that support CCS include Jaguar, Volkswagen, General Motors, BMW, Daimler, Ford, FCA, Tesla and Hyundai. The CSS standard is con-trolled by the so called CharlN consortium. Besides other protocols such as, for example, CHAdeMO, as abbreviation of CHArge de Move, or GBIT, in particular according to 20234.3-2011 standard. The proposed solution can be advantageously used with even higher charging currents such as or more than 500A, 600A or 3000A, voltages such as or higher 1000V, 1500V or 3000V and/or in combination with newer standards not yet defined requiring higher currents.

The EVSE may comprise a converter and preferably a transformer connected to an AC, alternating current, grid for receiving electrical energy, which is transformed and/or converted to DC, direct current, for charging a battery of the electric vehicle connected via the DC bus to the EVSE. The electric vehicle can be provided as a motor car, a bus, a van, a truck, a tractor or any other electrically powered vehicle. The EVSE may comprise an outlet port connected to the DC bus, to which a charging cable is connected, for connecting to the electrical vehicle via a charging connector. The charging cable and/or the charging connector are preferably associated charging standards, such as for instance CHAdeMO, CCS, GB, Tesla, etc., and/or are provided according to the standards described above. The EVSE may comprise a plurality of charging cables with respective charging connectors, for example each according to different charging standards.

In a preferred implementation the first test signal and the second test signal are applied simultaneously. The two frequencies i.e. the first frequency and the second frequency are preferably applied simultaneously, whereby each frequency preferably covers one corresponding requirement i.e. one frequency for fast and the other frequency for slow detection of the isolation respective an isolation fault

According to another preferred implementation the second fluctuation is band pass-filtered in respect to the first frequency and/or comprises a zero-phase delay in respect to the second frequency and the first fluctuation is band pass-filtered in respect to the second frequency and/or comprises a zero-phase delay in respect to the first frequency. By using such measures unwanted disturbances by the respective other frequency can be zeroed out. In a further preferred implementation band pass-filtering comprises a digital filter and/or a second order Bessel Infinite impulse response, IIR, band pass filter. In particular such Bessel IIR band pass filter leads to high accuracy.

According to another preferred implementation the first frequency is 0,5 Hz and the second frequency is 2,5 Hz. Alternatively the first frequency can be 0.25, 1, 2, 5 or 10 Hz and/or the second frequency can be 1.25, 5, 10, 20 or 50 Hz. The first periodical test signal and/or the second periodic test signal may comprise a voltage and/or a current course, for example 10 V or 20 V.

In a further preferred implementation the first periodical test signal and/or the second periodical test signal comprises a real part and an imaginary part, and the step of correlating comprises correlating the respective real part and the respective imaginary part separately with the band-pass filtered fluctuation, integrating the respective correlated parts separately and differentiating the respective integrated parts resulting in the respective vector.

According to another preferred implementation the step of determining comprises if multiple consecutive second vectors fall below the threshold, determining the ohmic isolation resistance of the DC bus by using the first vector, and if multiple consecutive second vectors exceed the threshold, determining the isolation of the DC bus by using the second vector. Such way the determining preferably starts using the fast vector for the detection calculations. If multiple consecutive samples of the fast vector are in a so called "forbidden zone", the slow vector can be used for the detection calculations. If then again multiple consecutive samples of the fast vector are outside the "forbidden zone", the fast vector for the detection calculations can be used again. The "forbidden zone" is thereby a certain combination of real and imaginary outputs from the correlation, simply characterized as threshold. In practise, if the capacitance gets too high, the vector will not be usable because noise, fluctuations and interference will dominate small useful signals. In other words, the slow and fast vectors i.e. the first vector and the second vector, are continuously calculated and it is observed if it is possible to use the fast vector, and if not, it can always be fallen back to the slow vector.

In a further preferred implementation the first frequency and the second frequency are phased shifted by ≥ 15°, ≥ 60°, ≥ 90°, ≥ 135° or ≥ 180°. Such way an output voltage swing can be optimized.

According to another preferred implementation the steps applying, measuring, band pass-filtering and subtracting, determining and correlating comprise test signals, fluctuations and vectors in respect to more than two different frequencies. The proposed method can thus be used for more than two frequencies respectively carriers. In such case for each carrier signals from all other filtered carriers have to be substracted in each processing path.

In a further preferred implementation the DC bus comprises an intentional resistance. With such implementation detection during high capacitance can be speed up.

The object is further solved by an electric vehicle supply equipment, EVSE, comprising
an ungrounded DC, direct current, bus for connecting an electric vehicle, EV, to the EVSE,
a test signal source configured for applying a first periodical test signal having a first frequency and for applying a second periodical test signal having a second frequency on the DC bus, whereby the second frequency is greater than the first frequency,
a measurement device configured for measuring a first voltage and/or current fluctuation on the DC bus resulting from the first test signal and for measuring a second voltage and/or current fluctuation on the DC bus resulting from the second test signal, and
an evaluation device configured for correlating the first test signal with the first fluctuation resulting in a first vector and for correlating the second test signal with the second fluctuation resulting in a second vector.

The evaluation device is further configured for band pass-filtering the second fluctuation and subtracting the band pass-filtered second fluctuation from the first fluctuation and for band pass-filtering the first fluctuation and subtracting the band pass-filtered first fluctuation from the second fluctuation, whereby correlating comprises correlating the first test signal with the band pass-filtered first fluctuation resulting in the first vector and for correlating the second test signal with the band pass-filtered second measured fluctuation resulting in the second vector.

In another preferred implementation the evaluation device is further configured for determining an isolation of the DC bus by using the second vector, and if the second vector falls below a threshold, for determining the isolation of the DC bus by using the first vector.

The test signal source is preferably provided as a DC voltage and/or current source, in particular connected to the DC bus, in particular to each DC+ and DC-, via each one test resistor. The measurement device can be provided as a computerized device connected to the DC bus, in particular to each DC+ and DC- via each one resistor. The evaluation device, also referred to as isolation monitor, can be provided as computerized device, in particular in one piece with the measurement device.

In a further preferred implementation the evaluation device comprises for the band pass-filtering a digital filter and/or a second order Bessel Infinite impulse response, IIR, band pass filter. In another preferred implementation the determining comprises if multiple consecutive second vectors fall below the threshold, determining the isolation of the DC bus by using the first vector, and if multiple consecutive second vectors exceed the threshold, determining the isolation of the DC bus by using the second vector.

In another preferred implementation the first frequency and the second frequency are phased shifted by ≥ 15°, ≥ 60°, ≥ 90°, ≥ 135° or ≥ 180°. In another preferred implementation the DC bus comprises an intentional resistance.

Further embodiments and advantages of the EVSE are directly and unambiguously derived by the person skilled in the art from the method as described before.

### Brief description of drawings

These and other aspects of the invention will be apparent from and elucidated with reference to the implementations described hereinafter.

In the drawings:
Fig. 1 shows a charging system as known from prior art,
Fig. 2 shows processing within an isolation monitor respectively evaluation device according to a preferred implementation,
Fig. 3 shows how two different frequencies interfere and thus affect each,
Fig. 4 shows a "forbidden zone" as a combination of real and imaginary outputs of a vector calculated by the processing scheme shown in Fig. 2,
Fig. 5 shows an example calculated by the processing scheme shown in Fig. 2 without phase shift with 20 V as first test signal at 0,5 Hz as first frequency and 10 V as second test signal at 2,5 Hz, and
Fig. 6 shows an example calculated by the processing scheme shown in Fig. 2 with phase shift 4 V peak reduction.

### Description of embodiments

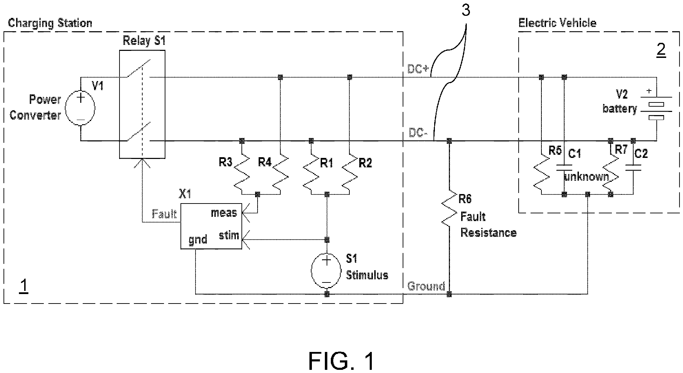

Fig. 1 shows a typical charging system as known from prior art for monitoring isolation comprising an electric vehicle supply equipment, EVSE, 1 and an electric vehicle, EV, 2. The EV 2 is connected to the EVSE 1 via a DC, direct current, bus 3 of the EVSE 1. The DC bus 3 comprises DC+ and DC- conductors as well as a ground respectively protective earth, PE, conductor. Thereby, the EVSE 1 is not connected to earth, while is ground respectively PE is locally connected to earth, thus forming an isolés terre earthing system. A voltage source S1 as test signal source S1 is connected via test resistors R1, R2 to DC- respectively DC+ to apply a periodic test signal, which is then measured via resistors R3, R4 as measurement device R3, R4 as impedance to ground and processed in an isolation monitor X1 as evaluation device X1. In case of an identified isolation fault power to the DC bus 3 can be switched of via relay S1.

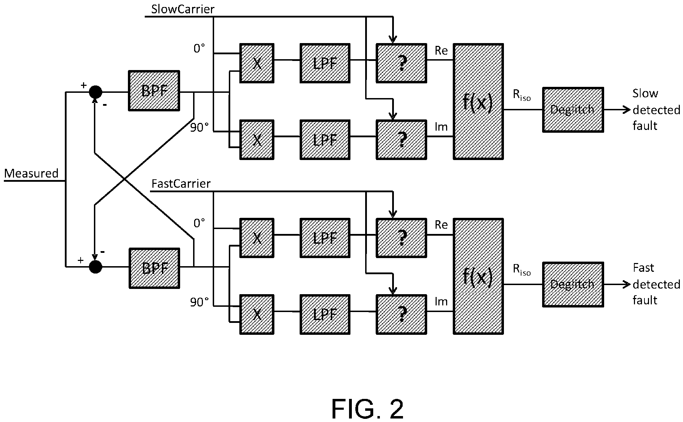

Fig. 2 shows processing within an isolation monitor X1 respectively evaluation device X1 according to a preferred implementation. In a first step two periodic test signals with different frequencies are applied onto the DC bus 3. Both test signals are applied simultaneously and may comprise a continuous voltage and/or current course with respect to ground. The test signals are applied via said test resistors R1, R2 to DC- respectively DC+. The first test signal has a first higher frequency of 2,5 Hz for fast detection and the second test signal has a lower frequency of 0,5 Hz. Having two different frequencies allows fast isolation monitoring when low capacitance is on the DC bus 3 and slow isolation monitoring when high capacitance is on the DC bus 3. Said low capacitance is usually present at a beginning of a charging session and in particular during a so called cable-check phase, when the EV 2 has not yet connected its batteries to the DC bus 3. In such phase a quick detection within few seconds is required, since detection time adds up to total charging session time. Once charging commences, high capacitance is usually present. Such wise the first frequency shall be used for slow detection, while the second frequency shall be used for fast detection.

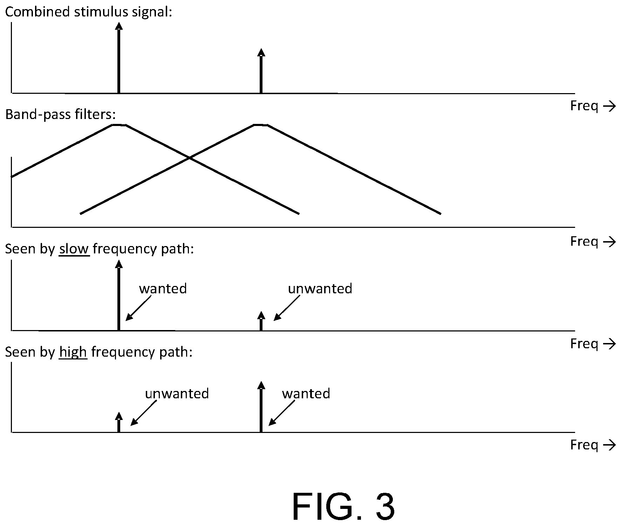

However, two different frequencies interfere and thus affect each other as can be seen from Fig. 3, where typical frequencies of 0,5 Hz as first frequency for slow detection and 2,5 Hz as second frequency for fast detection in EV charging differing only by a factor of 5 times are depicted, since band pass filter and correlators will not filter the frequencies completely out, as bandwidth cannot be limited to much due to sufficient fast response time required. Thus, significant inaccuracy up to 50% of the calculated isolation resistance will result. Further, a fast and solid way for determining usefulness of each frequency is required.

In order to overcome the first problem, the proposed solution, after having measured a first voltage and/or current fluctuation on the DC bus 3 resulting from the first test signal and measured a second voltage and/or current fluctuation on the DC bus 3 resulting from the second test signal, first subtracts the band pass-filtered fluctuation from the other (non-band pass-filtered) fluctuation, which result is then band pass-filter by a band pass-filter BPF, before correlation is performed, as depicted in Fig. 2. Specifically, the second fluctuation is band pass-filtered by the second band pass-filter-BPF and then subtracted from the first fluctuation.

The result from the subtraction is then band pass-filtered by the first band pass-filter BPF, prior to correlation as described next. Equally, the first fluctuation is band pass-filtered by the first band pass-filter BPF and then subtracted from the second fluctuation. The result from the subtraction is then band pass-filtered by the second band pass-filter BPF. Both band pass-filters BPF a zero-phase delay in respect to their wanted frequency such that unwanted disturbances by other frequencies can be zeroed out. Specifically, both band pass-filters BPF are provided as digital filters such as second order Bessel IIR band pass-filters.

Within the next correlation step, the first test signal is correlated with the band pass-filtered first fluctuations to result in a first and second vectors. Specifically, the first test signal is correlated with the band pass-filtered first fluctuation thereby resulting in a first vector and the second test signal with the band pass-filtered second measured fluctuation thereby resulting in a second vector. More specifically, the first periodical test signal and the second periodical test signal each comprise a real part and an imaginary part. Such wise both the real part and the imaginary part of the first test signal, referred to as slow carrier in Fig. 2, and of the second test signal, referred to as fast carrier in Fig. 2, are separately correlated with each other, the low pass filtered with a respective low pass filter LPF, thereafter separately integrated until the results thereof both from the real part and the imaginary part are differentiated, and finally deglitched by a respective deglitch filter element in order to obtain the first vector respectively the second vector.

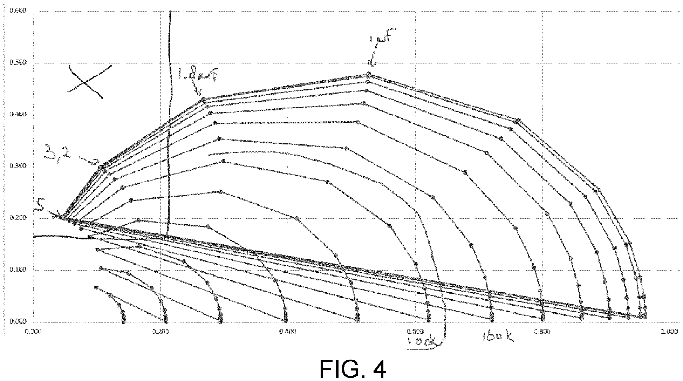

In a final step, also to solve the second problem mentioned above, isolation of the DC bus 3 respectively isolation fault is determined. Thereby, the second vector is used and, if the second vector falls below a threshold, determining the isolation of the DC bus 3 by using the first vector. Thus, slow and fast vectors are continuously calculated, and it is observed if the fast vector can be used, and, if not, always fall back to the slow vector. Specifically, first the fast vector is used. If multiple consecutive samples of the fast vector are in a so-called "forbidden zone" i.e. are below the threshold, the slow vector is used. If then multiple consecutive samples of the fast vector are outside the "forbidden zone" i.e. above the threshold, the fast vector is used. Thereby, the "forbidden zone" is a certain combination of the real and imaginary outputs of the vector, marked in Fig. 4 with a "X". Within said figure, lines of equal resistance are shown but with different capacitances. Typically, if the capacitance gets too high, the respective vector will not be usable because the noise, fluctuations and interference dominate the small useful signals. However, not usable signals are detectable as vector in the forbidden zone in the top left of Fig. 4.

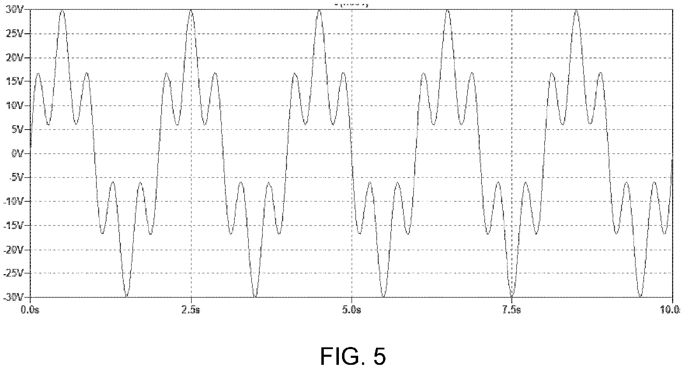

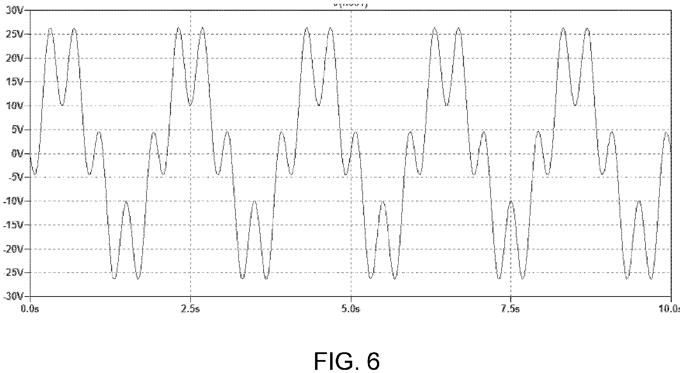

In a further implementation, not shown, first frequency and second frequency can be phase shifted by 180° from each other for optimizing an output voltage swing. Fig. 5 shows an example without phase shift with 20 V as first test signal at 0,5 Hz as first frequency and 10 V as second test signal at 2,5 Hz, whereas Fig. 6 shows an example with phase shift 4 V peak reduction. As can be seen, the slow carrier respectively the first frequency has the highest amplitude, since slow detection shall work in all possible situations and thus shall be as robust as possible.

Generally, the proposed method can be used with more than two frequencies respectively carriers, such that before described steps of applying, measuring, band pass-filtering and subtracting, determining and correlating are applied to more than two test signals, fluctuations and vectors. For speeding up detection during high capacitance, an intentional resistance R6 can be added to the DC bus 3.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: electric vehicle supply equipment
- 2: electrical vehicle
- 3: DC bus
- S1: test signal source
- X1: evaluation device
- BPF: band pass filter
- LPF: low pass filter
- R1, R2: test resistor
- R3, R4: measurement device
- R6: intentional resistance

## Claims

1. Method for monitoring isolation of an ungrounded DC, direct current, bus (3) of an electric vehicle supply equipment, EVSE, (1) comprising the steps of:
Applying a first periodical test signal having a first frequency and applying a second periodical test signal having a second frequency on the DC bus (3), whereby the second frequency is greater than the first frequency,
Measuring a first voltage and/or current fluctuation on the DC bus (3) resulting from the first test signal and measuring a second voltage and/or current fluctuation on the DC bus (3) resulting from the second test signal, and
Correlating the first test signal with the first fluctuation resulting in a first vector and correlating the second test signal with the second fluctuation resulting in a second vector, **characterised in** the method further comprising the steps of:
Band pass-filtering the second fluctuation and subtracting the band pass-filtered second fluctuation from the first fluctuation and band pass-filtering the first fluctuation and subtracting the band pass-filtered first fluctuation from the second fluctuation, and whereby the step of correlating comprises
Correlating the first test signal with the band pass-filtered first fluctuation resulting in the first vector and correlating the second test signal with the band pass-filtered second fluctuation resulting in the second vector.

2. Method according to any of the previous claims, comprising the step of:
Determining the isolation of the DC bus (3) by using the second vector and if the second vector falls below a threshold, determining the isolation of the DC bus (3) by using the first vector.

3. Method according to any of the previous claims, whereby the first test signal and the second test signal are applied simultaneously.

4. Method according to any of the previous claims, whereby the second fluctuation is band pass-filtered in respect to the first frequency and/or comprises a zero-phase delay in respect to the second frequency and the first fluctuation is band pass-filtered in respect to the second frequency and/or comprises a zero-phase delay in respect to the first frequency.

5. Method according to any of the previous claims, whereby band pass-filtering comprises a digital filter and/or a second order Bessel Infinite impulse response, IIR, band pass filter (BPF).

6. Method according to any of the previous claims, whereby the first frequency is 0.5 Hz and the second frequency is 2.5 Hz.

7. Method according to any of the previous claims, whereby the first periodical test signal and/or the second periodical test signal comprises a real part and an imaginary part, and the step of correlating comprises correlating the respective real part and the respective imaginary part separately with the band-pass filtered fluctuation, integrating the respective correlated parts separately and differentiating the respective integrated parts resulting in the respective vector.

8. Method according to any of the previous claims, whereby the step of determining comprises if multiple consecutive second vectors fall below the threshold, determining the isolation of the DC bus (3) by using the first vector, and if multiple consecutive second vectors exceed the threshold, determining the isolation of the DC bus (3) by using the second vector.

9. Method according to any of the previous claims, whereby the first frequency and the second frequency are phased shifted by ≥ 15°, ≥ 60°, ≥ 90°, ≥ 135° or ≥ 180°.

10. Method according to any of the previous claims, comprising applying, measuring, band pass-filtering and subtracting, determining and correlating test signals, fluctuations and vectors in respect to more than two different frequencies.

11. Method according to any of the previous claims, whereby the DC bus (3) comprises an intentional resistance (R6).

12. Electric vehicle supply equipment, EVSE, (1) comprising
an ungrounded DC, direct current, bus (3) for connecting an electric vehicle (2), EV, to the EVSE (1),
a test signal source (S1) configured for applying a first periodical test signal having a first frequency and for applying a second periodical test signal having a second frequency on the DC bus (3), whereby the second frequency is greater than the first frequency,
a measurement device (R3, R4) configured for measuring a first voltage and/or current fluctuation on the DC bus (3) resulting from the first test signal and for measuring a second voltage and/or current fluctuation on the DC bus (3) resulting from the second test signal, and
an evaluation device (X1) configured for:
correlating the first test signal with the first fluctuation resulting in a first vector and for correlating the second test signal with the second measured fluctuation resulting in a second vector, **characterised in that** the evaluation device (X1) is further configured for;
band pass-filtering the second fluctuation and subtracting the band pass-filtered second fluctuation from the first fluctuation and for band pass-filtering the first fluctuation and subtracting the band pass-filtered first fluctuation from the second fluctuation, whereby correlating comprises
correlating the first test signal with the band pass-filtered first fluctuation resulting in the first vector and for correlating the second test signal with the band pass-filtered second fluctuation resulting in the second vector.

13. EVSE (1) according to any of the previous EVSE (1) claims, whereby the evaluation device (X1) is further configured for determining the isolation of the DC bus (3) by using the second vector, and if the second vector falls below a threshold, for determining the isolation of the DC bus (3) by using the first vector.

14. EVSE (1) according to any of the previous EVSE (1) claims, whereby the evaluation device (X1) comprises for the band pass-filtering a digital filter and/or a second order Bessel Infinite impulse response, IIR, band pass filter (BPF).

15. EVSE (1) according to any of the previous EVSE (1) claims, whereby the determining comprises if multiple consecutive second vectors fall below the threshold, determining the isolation of the DC bus (3) by using the first vector, and if multiple consecutive second vectors exceed the threshold, determining the isolation of the DC bus (3) by using the second vector.

16. EVSE (1) according to any of the previous EVSE (1) claims, whereby the first frequency and the second frequency are phased shifted by ≥ 15°, ≥ 60°, ≥ 90°, ≥ 135° or ≥ 180°.

17. EVSE (1) according to any of the previous EVSE (1) claims, whereby the DC bus (3) comprises an intentional resistance (R6).

## Patentansprüche

1. Verfahren zur Überwachung der Isolierung einer ungeerdeten Gleichstromsammelschiene (3) einer elektrischen Fahrzeugversorgungseinrichtung (1), das die folgenden Schritte umfasst:
Anlegen eines ersten periodischen Testsignals mit einer ersten Frequenz und Anlegen eines zweiten periodischen Testsignals mit einer zweiten Frequenz an den DC-Bus (3), wobei die zweite Frequenz größer ist als die erste Frequenz,
Messen einer ersten Spannungs- und/oder Stromschwankung auf dem DC-Bus (3), die aus dem ersten Testsignal resultiert, und Messen einer zweiten Spannungs- und/oder Stromschwankung auf dem DC-Bus (3), die aus dem zweiten Testsignal resultiert, und
Korrelieren des ersten Testsignals mit der ersten Schwankung, was zu einem ersten Vektor führt, und Korrelieren des zweiten Testsignals mit der zweiten Schwankung, was zu einem zweiten Vektor führt,
**dadurch gekennzeichnet, dass** das Verfahren ferner die folgenden Schritte umfasst:
Bandpassfiltern der zweiten Schwankung und Subtrahieren der bandpassgefilterten zweiten Schwankung von der ersten Schwankung und Bandpassfiltern der ersten Schwankung und Subtrahieren der bandpassgefilterten ersten Schwankung von der zweiten Schwankung, und wobei der Schritt des Korrelierens umfasst
Korrelieren des ersten Testsignals mit der bandpassgefilterten ersten Schwankung, was zu dem ersten Vektor führt, und Korrelieren des zweiten Testsignals mit der bandpassgefilterten zweiten Schwankung, was zu dem zweiten Vektor führt.

2. Verfahren nach einem der vorhergehenden Ansprüche, umfassend den Schritt:
Bestimmen der Isolation des DC-Busses (3) unter Verwendung des zweiten Vektors und, wenn der zweite Vektor unter einen Schwellenwert fällt, Bestimmen der Isolation des DC-Busses (3) unter Verwendung des ersten Vektors.

3. Verfahren nach einem der vorhergehenden Ansprüche, wobei das erste Prüfsignal und das zweite Prüfsignal gleichzeitig angelegt werden.

4. Verfahren nach einem der vorhergehenden Ansprüche, wobei die zweite Schwankung in Bezug auf die erste Frequenz bandpassgefiltert ist und/oder eine Nullphasenverzögerung in Bezug auf die zweite Frequenz aufweist und die erste Schwankung in Bezug auf die zweite Frequenz bandpassgefiltert ist und/oder eine Nullphasenverzögerung in Bezug auf die erste Frequenz aufweist.

5. Verfahren nach einem der vorhergehenden Ansprüche, wobei die Bandpassfilterung ein digitales Filter und/oder ein IIR-Bandpassfilter (Bessel Infinite Impulse Response) zweiter Ordnung umfasst.

6. Verfahren nach einem der vorhergehenden Ansprüche, wobei die erste Frequenz 0,5 Hz und die zweite Frequenz 2,5 Hz beträgt.

7. Verfahren nach einem der vorhergehenden Ansprüche, wobei das erste periodische Testsignal und/oder das zweite periodische Testsignal einen Realteil und einen Imaginärteil umfasst und der Schritt des Korrelierens das getrennte Korrelieren des jeweiligen Realteils und des jeweiligen Imaginärteils mit der bandpassgefilterten Schwankung, das getrennte Integrieren der jeweiligen korrelierten Teile und das Differenzieren der jeweiligen integrierten Teile umfasst, was zu dem jeweiligen Vektor führt.

8. Verfahren nach einem der vorhergehenden Ansprüche, wobei der Schritt des Bestimmens darin besteht, dass, wenn mehrere aufeinanderfolgende zweite Vektoren den Schwellenwert unterschreiten, die Isolation des DC-Busses (3) unter Verwendung des ersten Vektors bestimmt wird, und dass, wenn mehrere aufeinanderfolgende zweite Vektoren den Schwellenwert überschreiten, die Isolation des DC-Busses (3) unter Verwendung des zweiten Vektors bestimmt wird.

9. Verfahren nach einem der vorhergehenden Ansprüche, wobei die erste Frequenz und die zweite Frequenz um ≥ 15°, ≥ 60°, ≥ 90°, ≥ 135° oder ≥ 180° phasenverschoben sind.

10. Verfahren nach einem der vorhergehenden Ansprüche, umfassend das Anwenden, Messen, Bandpassfiltern und Subtrahieren, Bestimmen und Korrelieren von Testsignalen, Schwankungen und Vektoren in Bezug auf mehr als zwei verschiedene Frequenzen.

11. Verfahren nach einem der vorhergehenden Ansprüche, wobei der Gleichstrombus (3) einen absichtlichen Widerstand (R6) aufweist.

12. Versorgungseinrichtung für Elektrofahrzeuge, EVSE, (1) bestehend aus
einen ungeerdeten Gleichstrombus (3) zum Anschluss eines Elektrofahrzeugs (2), EV, an die EVSE (1),
eine Testsignalquelle (S1), die zum Anlegen eines ersten periodischen Testsignals mit einer ersten Frequenz und zum Anlegen eines zweiten periodischen Testsignals mit einer zweiten Frequenz an den Gleichstrombus (3) eingerichtet ist, wobei die zweite Frequenz größer als die erste Frequenz ist,
eine Messvorrichtung (R3, R4), die zum Messen einer ersten Spannungs- und/oder Stromschwankung auf dem DC-Bus (3), die aus dem ersten Testsignal resultiert, und zum Messen einer zweiten Spannungs- und/oder Stromschwankung auf dem DC-Bus (3), die aus dem zweiten Testsignal resultiert, eingerichtet ist, und
ein Auswertegerät (X1), eingerichtet für:
das erste Testsignal mit der ersten Schwankung zu korrelieren, was zu einem ersten Vektor führt, und das zweite Testsignal mit der zweiten gemessenen Schwankung zu korrelieren, was zu einem zweiten Vektor führt,
**dadurch gekennzeichnet, dass** das Auswertegerät (X1) weiterhin dafür eingerichtet ist:
Bandpassfiltern der zweiten Schwankung und Subtraktion der bandpassgefilterten zweiten Schwankung von der ersten Schwankung und zur Bandpassfilterung der ersten Schwankung und Subtraktion der bandpassgefilterten ersten Schwankung von der zweiten Schwankung, wobei das Korrelieren umfasst
Korrelieren des ersten Testsignals mit der bandpassgefilterten ersten Schwankung, die den ersten Vektor ergibt, und Korrelieren des zweiten Testsignals mit der bandpassgefilterten zweiten Schwankung, die den zweiten Vektor ergibt.

13. EVSE (1) nach einem der vorhergehenden Ansprüche, wobei die Auswerteeinrichtung (X1) weiterhin dazu ausgebildet ist, die Isolation des Zwischenkreises (3) unter Verwendung des zweiten Vektors zu bestimmen und, wenn der zweite Vektor einen Schwellenwert unterschreitet, die Isolation des Zwischenkreises (3) unter Verwendung des ersten Vektors zu bestimmen.

14. EVSE (1) nach einem der vorhergehenden EVSE (1)-Ansprüche, wobei die Auswerteeinrichtung (X1) für die Bandpassfilterung ein digitales Filter und/oder ein Bessel-Bandpassfilter (BPF) zweiter Ordnung mit unendlicher Impulsantwort (IIR) umfasst.

15. EVSE (1) nach einem der vorhergehenden Ansprüche, wobei das Bestimmen umfasst, wenn mehrere aufeinanderfolgende zweite Vektoren unter den Schwellenwert fallen, das Bestimmen der Isolation des DC-Busses (3) unter Verwendung des ersten Vektors, und wenn mehrere aufeinanderfolgende zweite Vektoren den Schwellenwert überschreiten, das Bestimmen der Isolation des DC-Busses (3) unter Verwendung des zweiten Vektors.

16. EVSE (1) nach einem der vorhergehenden Ansprüche, wobei die erste Frequenz und die zweite Frequenz um ≥ 15°, ≥ 60°, ≥ 90°, ≥ 135° oder ≥ 180° phasenverschoben sind.

17. EVSE (1) nach einem der vorhergehenden Ansprüche, wobei der Gleichstrombus (3) einen beabsichtigten Widerstand (R6) aufweist.

## Revendications

1. Procédé de surveillance de l'isolation d'un bus à courant continu, CC, non mis à la terre (3) d'un équipement d'alimentation de véhicule électrique, EVSE, (1) comprenant les étapes de :
application d'un premier signal de test périodique ayant une première fréquence et application d'un second signal de test périodique ayant une seconde fréquence sur le bus CC (3), la seconde fréquence étant supérieure à la première fréquence,
mesure d'une première fluctuation de tension et/ou de courant sur le bus CC (3) résultant du premier signal de test et mesure d'une seconde fluctuation de tension et/ou de courant sur le bus CC (3) résultant du second signal de test, et
corrélation du premier signal de test avec la première fluctuation résultant en un premier vecteur et corrélation du second signal de test avec la seconde fluctuation résultant en un second vecteur, **caractérisé en ce que** le procédé comprend en outre les étapes de :
filtrage passe-bande de la seconde fluctuation et soustraction de la seconde fluctuation filtrée en passe-bande de la première fluctuation, et filtrage passe-bande de la première fluctuation et soustraction de la première fluctuation filtrée en passe-bande de la seconde fluctuation, l'étape de corrélation comprenant :
la corrélation du premier signal de test avec la première fluctuation filtrée en passe-bande, résultant en le premier vecteur, et la corrélation du second signal de test avec la seconde fluctuation filtrée en passe-bande, résultant en le second vecteur.

2. Procédé selon l'une quelconque des revendications précédentes, comprenant l'étape de :
détermination de l'isolation du bus CC (3) en utilisant le second vecteur et si le second vecteur tombe en dessous d'un seuil, détermination de l'isolation du bus CC (3) en utilisant le premier vecteur.

3. Procédé selon l'une quelconque des revendications précédentes, le premier signal de test et le second signal de test étant appliqués simultanément.

4. Procédé selon l'une quelconque des revendications précédentes, la seconde fluctuation étant filtrée en passe-bande par rapport à la première fréquence et/ou comprenant un retard de phase nul par rapport à la seconde fréquence et la première fluctuation étant filtrée en passe-bande par rapport à la seconde fréquence et/ou comprenant un retard de phase nul par rapport à la première fréquence.

5. Procédé selon l'une quelconque des revendications précédentes, le filtrage passe-bande comprenant un filtre numérique et/ou un filtre passe-bande (BPF) Bessel de deuxième ordre à réponse impulsionnelle infinie, IIR.

6. Procédé selon l'une quelconque des revendications précédentes, la première fréquence étant de 0,5 Hz et la seconde fréquence étant de 2,5 Hz.

7. Procédé selon l'une quelconque des revendications précédentes, le premier signal de test périodique et/ou le second signal de test périodique comprenant une partie réelle et une partie imaginaire, et l'étape de corrélation comprenant la corrélation de la partie réelle respective et de la partie imaginaire respective séparément avec la fluctuation filtrée en passe-bande, l'intégration des parties corrélées respectives séparément et la différenciation des parties intégrées respectives résultant en le vecteur respectif.

8. Procédé selon l'une quelconque des revendications précédentes, l'étape de détermination comprenant si plusieurs seconds vecteurs consécutifs tombent en dessous du seuil, la détermination de l'isolation du bus CC (3) en utilisant le premier vecteur, et si plusieurs seconds vecteurs consécutifs dépassent le seuil, la détermination de l'isolation du bus CC (3) en utilisant le second vecteur.

9. Procédé selon l'une quelconque des revendications précédentes, la première fréquence et la seconde fréquence étant déphasées de ≥ 15°, ≥ 60°, ≥ 90°, ≥ 135° ou ≥ 180°.

10. Procédé selon l'une quelconque des revendications précédentes, comprenant l'application, la mesure, le filtrage passe-bande et la soustraction, la détermination et la corrélation de signaux de test, de fluctuations et de vecteurs par rapport à plus de deux fréquences différentes.

11. Procédé selon l'une quelconque des revendications précédentes, le bus CC (3) comprenant une résistance intentionnelle (R6).

12. Équipement d'alimentation de véhicule électrique, EVSE, (1) comprenant :
un bus à courant continu, CC, non mis à la terre (3) pour connecter un véhicule électrique (2), EV, à l'EVSE(1),
une source de signaux de test (S1) configurée pour appliquer un premier signal de test périodique ayant une première fréquence et pour appliquer un second signal de test périodique ayant une seconde fréquence sur le bus CC (3), la seconde fréquence étant supérieure à la première fréquence,
un dispositif de mesure (R3, R4) configuré pour mesurer une première fluctuation de tension et/ou de courant sur le bus CC (3) résultant du premier signal de test et pour mesurer une seconde fluctuation de tension et/ou de courant sur le bus CC (3) résultant du second signal de test, et
un dispositif d'évaluation (X1) configuré pour :
corréler le premier signal de test avec la première fluctuation résultant en un premier vecteur et pour corréler le second signal de test avec la seconde fluctuation mesurée résultant en un second vecteur, **caractérisé en ce que** le dispositif d'évaluation (X1) est en outre configuré pour :
le filtrage passe-bande de la seconde fluctuation et la soustraction de la seconde fluctuation filtrée en passe-bande de la première fluctuation, et le filtrage passe-bande de la première fluctuation et la soustraction de la première fluctuation filtrée en passe-bande de la seconde fluctuation, la corrélation comprenant :
la corrélation du premier signal de test avec la première fluctuation filtrée en passe-bande, résultant en le premier vecteur, et la corrélation du second signal de test avec la seconde fluctuation filtrée en passe-bande, résultant en le second vecteur.

13. EVSE (1) selon l'une quelconque des revendications précédentes d'EVSE (1), le dispositif d'évaluation (X1) étant en outre configuré pour déterminer l'isolation du bus CC (3) en utilisant le second vecteur, et si le second vecteur tombe en dessous d'un seuil, pour déterminer l'isolation du bus CC (3) en utilisant le premier vecteur.

14. EVSE (1) selon l'une quelconque des revendications précédentes d'EVSE (1), le dispositif d'évaluation (X1) comprenant pour le filtrage passe-bande un filtre numérique et/ou un filtre passe-bande (BPF) Bessel de deuxième ordre à réponse impulsionnelle infinie, IIR.

15. EVSE (1) selon l'une quelconque des revendications précédentes d'EVSE (1), la détermination comprenant si plusieurs seconds vecteurs consécutifs tombent en dessous du seuil, la détermination de l'isolation du bus CC (3) en utilisant le premier vecteur, et si plusieurs seconds vecteurs consécutifs dépassent le seuil, la détermination de l'isolation du bus CC (3) en utilisant le second vecteur.

16. EVSE (1) selon l'une quelconque des revendications précédentes d'EVSE (1), la première fréquence et la seconde fréquence étant déphasées de ≥ 15°, ≥ 60°, ≥ 90°, ≥ 135° ou ≥ 180°.

17. EVSE (1) selon l'une quelconque des revendications précédentes d'EVSE (1), le bus CC (3) comprenant une résistance intentionnelle (R6).
